Europäisches Patentamt

(19) **European Patent Office**

Office européen des brevets

(11) Publication number: **0 255 973**
A2

# (12) EUROPEAN PATENT APPLICATION

(21) Application number: **87201420.4**

(22) Date of filing: **23.07.87**

(51) Int. Cl.⁴: **H 01 L 29/52**
**H 01 L 21/285**

(30) Priority: **08.08.86 US 894415**

(43) Date of publication of application:
**17.02.88 Bulletin 88/07**

(84) Designated Contracting States:
**BE DE FR GB IT NL**

(71) Applicant: **SILICONIX incorporated**
**2201 Laurelwood Road**
**Santa Clara California 95054 (US)**

(72) Inventor: **Blanchard, Richard A.**
**10724 Mora Drive**
**Los Altos California 94022 (US)**

(74) Representative: **Noz, Franciscus Xaverius, Ir. et al**
**Boschdijk 155 P.O. Box 645**
**NL-5600 AP Eindhoven (NL)**

(54) Contacts formed in minimum surface area of semiconductor devices.

(57) A technique for providing a contact to regions of a substrate (12) using a minimum of substrate surface (13) area by anisotropically etching a vertical trench (30) exposing silicon for preferential deposit of conductive material (40), such as tungsten, to form a contact.

FIG. 14c

Fig 14d

EP 0 255 973 A2

**Description**

## CONTACTS FORMED IN MINIMUM SURFACE AREA OF SEMICONDUCTOR DEVICES

### BACKGROUND OF THE INVENTION

This invention concerns semiconductor devices, and more specifically a technique of forming a vertical contact for connecting a conductive lead to one region or to several adjacent regions of a semiconductor substrate, using a minimum area on the substrate surface.

Integrated circuit (IC) and other semiconductor device dimensions are generally minimized to reduce current path lengths, capacitances, signal propagation delays, and power dissipation, to improve performance, and to lower manufacturing costs because of smaller overall device sizes.

IC design rules allow for manufacturing alignment tolerances in specifying minimum dimensions and spacings for circuit elements. In IC devices having a large number of contacts between conductive metallization layers and substrate regions, the contact areas can represent a substantial portion of the device size. The contact area required is particularly significant in devices such as vertical double-diffused metal oxide semiconductor (DMOS) transistors, which need conductor contacts common to, and shorting the junction(s) between, two or more adjacent regions of the device.

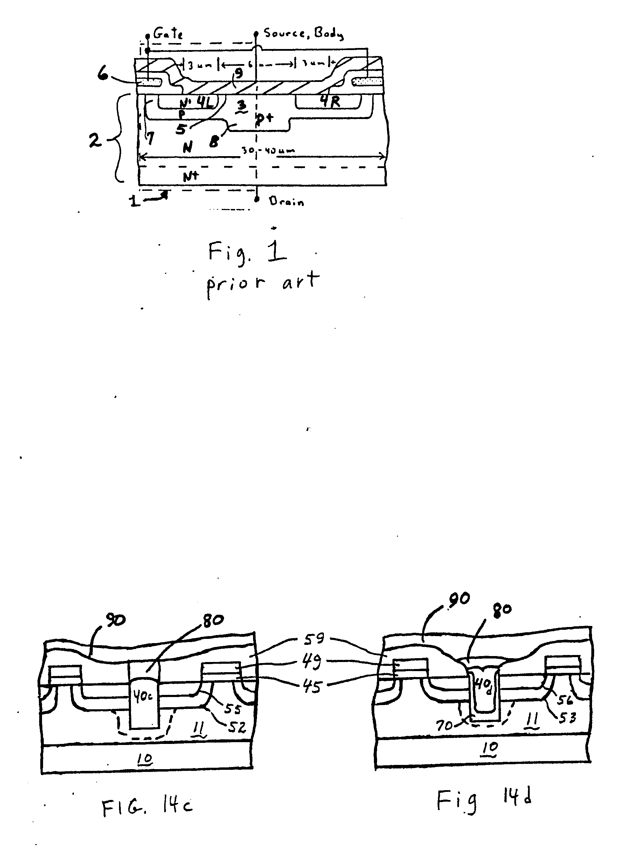

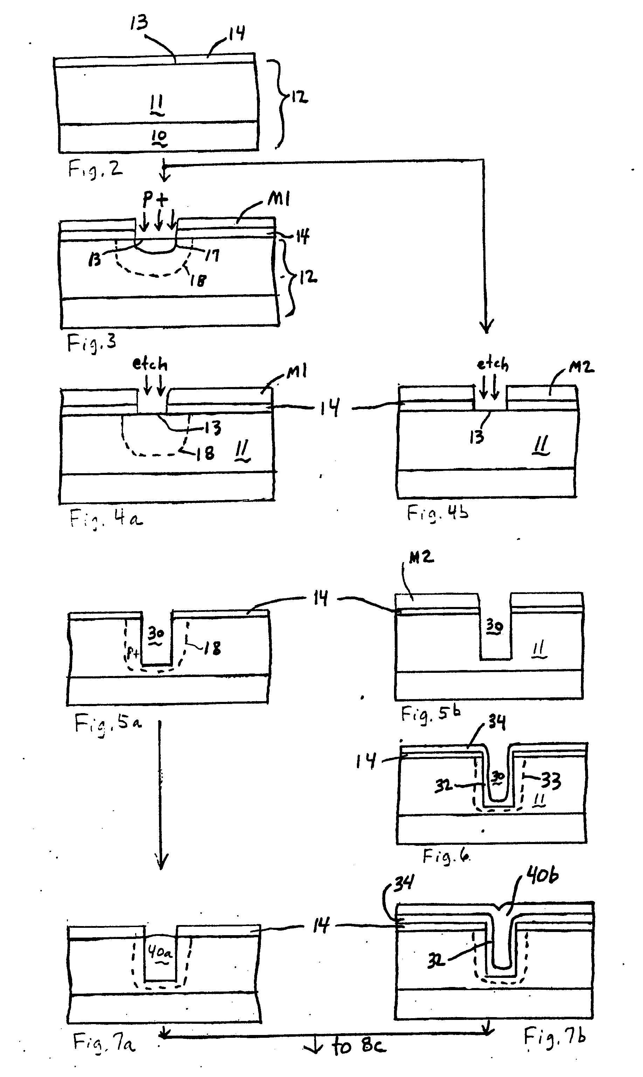

Referring to Fig. 1, a conventional N channel vertical DMOS power transistor cell 1 includes an N type conductivity monocrystalline silicon substrate drain 2, a P type conductivity channel body diffusion 3 beneath the initial top surface 5 of substrate 2, and a smaller N type conductivity source diffusion 4 inside P type body diffusion 3. On substrate surface 5 over channel body 3, gate oxide insulation supports a gate electrode 6, through which an applied control signal establishes an electric field to form a conduction channel 7 within body region 3 for conducting electrons from source diffusion 4 to substrate drain 2.

A power-switching DMOS device typically includes many such DMOS cells 1 positioned side-by-side on a common substrate 2, and connected in parallel to conduct a large total current. The gate electrode 6 above channel 7 extends across top surface 5 of drain 2 and over another channel 7 in a neighboring DMOS cell, not shown. Each body region 3 has laterally opposite left and right ends containing respective source regions 4L and 4R, for adjacent cells 1. The sources 4 are connected together, and the gates 6 are connected together. Unfortunately, N type region 2, P type region 3, and N type region 4 together form a parasitic NPN bipolar transistor which turns on if the PN junction between source 4 and body 3 becomes forward biased by leakage, avalanche, or photo- or particle-generated current collected by P- body region 3 and flowing laterally below source region 4 and in the body region 3 reach-through up to body contact 9. To prevent forward biasing, this junction is shorted by common contact 9 on surface 5, remote from channels 7. Shorting contact 9 cannot be near a channel 7 because it would interfere with inverting charge in the channel. The center portion 8 of body 3, between source regions 4, is typically made deeper and more conductive to divert current from the source 4-body 3 junction. Thus, in a DMOS device 1 with typical cross section dimensions as illustrated in Fig. 1, each source-body contact 9 must contact a three micron square area of each of source regions 4L and 4R, plus a 6 micron square area of body 3, occupying a total of $(12 \ \mu m)^2$ in a cell occupying a total of $(30\mu m)^2$ to $(35\mu m)^2$. Such a prior art DMOS device can be manufactured by a process as described in U.S. Patent No. 4,516,143.

Because IC cost is generally proportional to feature size, and for other reasons mentioned above, it is desirable to reduce the surface area used to make a contact to one or to multiple regions

Prior art techniques, for example U.S. patents No. 3,913,124 to Roberson and No. 4,333,227 to Horng et al, have economized IC surface area by providing vertical contacts to buried regions. In Roberson, a wafer supports an epitaxial layer having a top surface in a <100> plane, which is anisotropically etched to form a V-shaped trench having <111> sidewalls. The trench walls are covered with dielectric leaving an opening in the bottom of the trench, in which silicon is deposited to contact the wafer. Eliminating dielectric from portions of the sidewalls would allow exposed silicon surfaces of multiple regions to be preferentially contacted by deposited tungsten (instead of silicon). However, Roberson's anisotropic etching forms trench sidewalls at an angle of approximately 54°. Hence a V trench having a width of 2 microns in contact with a buried layer at a depth of 5 microns will have a width of approximately 10 microns at the substrate surface, which is not as small as desired.

In Horng et al, a semiconductor wafer supports a lightly doped epitaxial layer. Reactive ion etched (RIE) vertical trenches are filled with chemical vapor deposited (CVD) oxide, and the top surface of the epitaxial layer is more heavily doped. To form a vertical contact to the lightly doped buried part of the epitaxial layer, the CVD oxide is etched, to beneath the epitaxial layer because oxide vertical etch depth is generally difficult to control, after which low temperature differential oxidation forms thick oxide over the heavily doped exposed part of the wafer and the heavily doped upper part of the epitaxial layer, and forms thin oxide over the lightly doped lower part of the epitaxial layer. The differential oxide is then etched just enough to remove the thin oxide. Polycrystalline silicon is filled in to make a vertical contact to the buried epitaxial layer. This prior art technique may allow self aligned masking, but involves very complex processing which is unnecessary for many IC devices. Such complex processing is also expensive, time consuming, and often not satisfactorily repeatable.

## SUMMARY

The inventive method reduces the surface area used to form a contact between an overlying conductive lead and one or more regions in a silicon substrate by anisotropically etching a narrow vertical trench exposing the surrounding substrate region or regions in areas sufficient to form a contact, and refilling the trench by chemical vapor deposition of a conductive material which if desired deposits preferentially on silicon. The invention economizes IC surface area in contacting a single region, and especially in contacting multiple regions.

In a DMOS or insulated gate bipolar transistor, the invention provides a vertical contact between two adjacent surface source regions, and descending to a channel body layer buried beneath the surface regions, eliminating the need for the channel body region to reach upward to, and occupy a certain area of, the substrate surface in order to be connected with a conductive lead disposed over the surface. With cells having vertical contacts as narrow as two microns, total cell width is 25 microns, compared to planar contacts 12 microns wide in prior art cells having a total width of 35 microns, whereby the invention achieves a cell size only $(25/35)^2 = 51\%$ as large as the size of prior art cells.

The vertical contact replaces the channel body region reach-through up to the substrate surface, thereby reducing the length of the pinched body resistor beneath the source-body junction which can be biased by lateral current flow to the contact, and reducing DV/dt sensitivity in DMOS devices, or increasing the current required for latching in insulated gate bipolar transistor (IGBT) devices.

In addition, the trench etch-depth tolerance can be relieved by an intermediate step of lining the trench with polycrystalline silicon of appropriate conductivity.

## BRIEF DESCRIPTION OF THE DRAWING

Fig. 1 is a cross section of a conventional DMOS transistor with a common contact to the upper surfaces of adjacent regions;

Figs. 2 through 7a and 7b illustrate alternate sequences for providing a vertical trench and contact before diffusions for active devices in a semiconductor substrate;

Figs. 8c through 14c illustrate steps following Figs. 7a and 7b; and

Figs. 8d through 14d illustrate a sequence for providing diffusions and then a vertical contact with a trench lining of silicon.

## DETAILED DESCRIPTION

Semiconductor devices with vertical contacts according to this invention are preferably fabricated starting with a monocrystalline silicon wafer 10 having a <100> crystal index top surface, and having a bulk resistivity of 0.02 ohms/cm. Alternately, a wafer with a top surface in a crystal plane other than <100> could be used, depending on the shape of contact trench desired. On wafer 10, Fig. 2, N doped silicon is epitaxially grown to form epitaxial layer 11 approximately 13.5 microns thick, with a bulk resistivity of 2.4 ohms/cm, and having upper surface 13. Wafer 10 and epitaxial layer 11 together comprise substrate 12.

Using substrate 12, vertical contact trenches can be etched before, between, or after introduction of dopants in various regions to form semiconductor devices. To provide vertical contacts before doping source and channel body regions for a DMOS or IGBT device, surface 13 is thermally oxidized to form post-epitaxial oxide layer 14 having a thickness of 4000 to 10,000Å.

Optionally, referring to Fig. 3, a P+ deep body region may be provided at this stage by using mask M1 to etch oxide 14, after which exposed areas of surface 13 are doped, for example with boron by implanting ions less than one micron deep to form body well 17. Substrate 12 is then heated to expand boron well 17 by diffusion to area 18 three to five microns deep, with a sheet resistance within the range of 10 to 40 ohms/square, Fig. 3.

Alternatively, if optional deep body well 18 is not desired at this stage, then after the step of Fig. 2, a trench mask M2 is used, Fig. 4b, while oxide layer 14 is reactive ion or plasma-etched, using for example, an IPC-Branson 6540 plasma etcher at 1,200 watts with a gas mixture flow of 3,600 cc/min helium, 1,200 cc/min Freon 116 , and 350 cc/min Freon 23 , at a pressure of 8.0 torr, for 15 seconds.

After patterning oxide 14, mask M1, Fig. 4a, may be removed or left in place while epitaxial silicon 11 exposed surface areas 13 (Fig. 4a or 4b) are reactive ion- or plasma-etched by, for example, a Drytek 100 etching machine using a mixture of 50 cc/min $SF_6$ (sulfur hexafloride) and 50 cc/min Freon 115 gas, at a pressure of 0.150 torr, for 16 minutes at a power of 550 watts. Plasma or reactive ion etching forms a narrow, nearly vertical walled trench 30 as in Fig. 5a centered in deep body P well 18, or as in Fig. 5b. RIE is usually more directional than plasma etching, giving very deep, narrow profiles, with sidewalls varying less than 10% from top to bottom of a 5μm deep trench.

After the step of Fig. 5b, optional deep body doping 33 can be provided by chemical vapor deposition of polycrystalline silicon with P type dopant, forming a thin (preferably less than one-quarter the width of trench 30) lining 32 inside trench 30, as well as a layer 34 on the surface of oxide 14, Fig. 6. The polycrystalline silicon 32 P type doping concentration must be sufficiently light to be converted to N+ conductivity by a subsequent N+ source doping step, for lining 32 to make good ohmic contacts to both the later formed P- type body and N+ type source regions (Fig. 11a or 11b). Subsequent heating causes polycrystalline silicon 32 P type dopant to diffuse laterally into epitaxial layer 11 to form a deep body region as indicated by dashed lines 33 around trench 30, Fig. 6. Lining 32 relieves the critically or tolerance in the depth of trench 30.

Alternatively, if no deep body P well 18 (Fig. 3) or 33 (Fig. 6) is desired, such as when forming a vertical contact to previously doped layers in a substrate, polycrystalline silicon lining 32 can be deposited without doping, or omitted altogether.

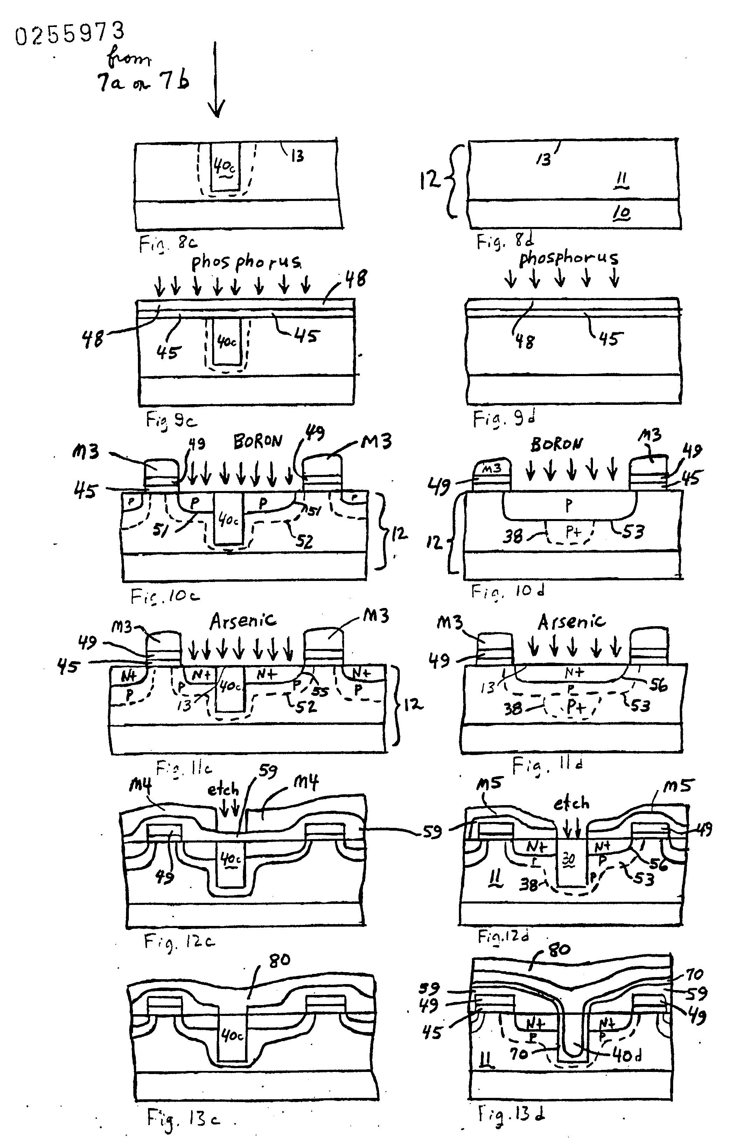

Following etching trench 30 and the optional deposit and doping of polycrystalline silicon lining 32, the monocrystalline or polycrystalline surface of trench 30 is covered by preferential deposition from a chemical vapor of conductive material, such as tungsten, to form contact 40a, Fig. 7a, or 40b, Fig. 7b. After the step of Fig. 7a, oxide 14 is removed, or after the step of Fig. 7b tungsten 40b, polycrystalline silicon 34, and oxide 14 are each removed, sufficiently to leave the filled-in trench 30 top essentially flush with substrate surface 13, Fig. 8c.

Alternatively, formation of vertical trench contact 30 can be postponed until after source and drain diffusions by beginning with substrate 12 as in Fig. 8d.

Next, for the sequence of either Fig. 8c or 8d, an active area mask is typically applied, not shown, exposing surface 13 areas for active devices formed as desired outside the regions shown in Fig. 8c or Fig. 8d. After active area masking, etching, and mask removal, using suitable techniques, surface 13 is covered with approximately 1,000Å of gate oxide 45, followed by approximately 5,000Å of polycrystalline silicon 48, Fig. 9c or 9d, which is then blanket doped with a suitable concentration of phosphorus, for example.

If desired, a deep body P well 38 may be provided at this stage, Fig. 10d, as in the step of Fig. 3.

Referring to Fig. 10c or 10d, polycrystalline silicon 48 is covered with mask M3, and etched to leave behind polycrystalline silicon gate electrodes 49. Gate oxide 45 can be removed or left in place for protection over diffusion areas, depending on subsequent implantation damage, diffusions, etc. Boron atoms, for example, are implanted to form P type channel body regions 51. Substrate 12 is then heated so that boron diffusion expands doped region 51 to, for example, a five micron deep junction 52, Fig. 10c, or 53, Fig. 10d.

After boron doping, mask M3 is left in place while surface 13 areas are implanted, for example, with arsenic ions (penetrating less deeply than lighter boron ions implanted at equal energy), to form shallow N+ regions 55 (Fig. 11c) or 56 (Fig. 11d), doped with 7 x 10E19 atoms/cm³. After diffusion of P region 52 and N region 55, if a polycrystalline silicon lining 32 has been provided (Fig. 6), then in the step of Fig. 11c, substrate 12 must be heated appropriately to diffuse source 55 N type dopants and body 52 P type dopants into, to impart their conductivity type to, and establish good ohmic contact with, polycrystalline silicon lining 32.

Next, polycrystalline silicon gate 49 is typically insulated, for example with oxide 59, Figs. 12c and 12d.

In the step of Fig. 12c, in which trench 30 was etched and contact 40c formed earlier, contact mask M4 is used for removal of any oxide 59 on the top of tungsten 40c, and typically from conductor lead external connection pads (not shown).

In the step of Fig. 12d, where no trench 30 has yet been formed, a trench mask M5 is applied, oxide 59 is etched (as was oxide 14 in the step of Fig. 4b), and plasma or reactive ion etching opens a trench through diffusions 56 and 53 into epitaxial layer 11, as in the step of Fig. 5a or Fig. 5b, and as shown in Fig. 12d. If epitaxial layer 11 has not been provided with a deep body P well 38, then, as in the step of Fig. 6, trench 30 may be lined with P doped polycrystalline silicon lining 70, Fig. 13d, which requires later heating to diffuse P type dopant into the adjoining substrate 11.

Polycrystalline silicon lining 70 or exposed epitaxial silicon 11 surfaces of trench 30 are preferentially covered by chemical vapor deposited tungsten 40d, Fig. 13d. Tungsten 40d (and polycrystalline silicon 70, if present) is then masked and etched except from the top of trench 30.

After active devices are formed and vertical contact upper surfaces are exposed as in Fig. 13c or 13d, the device is completed conventionally. A conductive metallization layer, preferably aluminum or an allow of aluminum, is deposited over the top surface of the structure. A metallization mask, not shown, is used to pattern the conductive layer to form an electrical interconnect network, not shown. Finally, passivation is deposited, masked, and etched, leads are connected, and the device is packaged and tested by well known techniques.

A preferred embodiment has been illustrated, of which modifications and adaptations within the scope of the invention will occur to those skilled in the art. For example, conductivity types may be interchanged to form a P-channel DMOS device. The invention is limited only by the scope of the following claims.

**Claims**

1. A process for providing a vertical contact connecting at least one region beneath the surface of a silicon substrate to a metallization lead over the surface, characterized by the steps of:

protecting said surface with a mask exposing a selected area;

anisotropically etching said selected area to form a trench with steep walls exposing areas of at least one region beneath said surface; and

depositing conductive contact material by selective chemical vapor deposition on exposed silicon sidewalls of the trench to form a vertical contact.

2. The process of Claim 1 characterized by beginning with a substrate having a top surface in a <100> crystal index plane.

3. The process of Claim 1 characterized by the anisotropic etching being plasma etching.

4. The process of Claim 1 characterized by the anisotropic etching being reactive ion etching.

5. A process as in Claim 1 characterized by the contact being for connecting a conductor to a substrate region which has already been doped.

6. The process of Claim 5 characterized by beginning with a first conductivity type substrate, within which a first region is doped second conductivity type, within which first region a smaller second region is doped first conductivity type, and wherein the trench penetrates from said surface down through the first and second regions.

7. The process of Claim 6 characterized by substrate regions adjacent the contact trench comprising a DMOS transistor.

8. The process of Claim 6 characterized by substrate regions adjacent the contact trench comprising an insulated gate bipolar transistor.

9. The process of Claim 6 characterized by the first conductivity type being N and the second conductivity type being P.

10. The process of Claim 1 characterized by the step of etching being followed by chemical vapor deposition of polycrystalline silicon to provide a lining inside the trench.

11. The process of Claim 10 characterized by chemical vapor deposition providing a polycrystalline silicon lining at a selected light second conductivity doping, and after deposition, the lining and substrate are heated to diffuse substrate dopant into, and impart its type conductivity to, the trench lining.

12. The process of Claim 10 characterized by the polycrystalline silicon lining having a selected second conductivity doping concentration for later diffusion to increase the second conductivity of the body region.

13. The process of Claim 1 characterized by the conductive material comprising polycrystalline silicon.

14. The process as in Claim 1 characterized by the conductive contact material being tungsten.

15. The process as in Claim 5 characterized by the step of forming a contact in the trench being followed by the step of depositing metallization over said contact.

16. The process as in Claim 15 characterized by the metallization being aluminum.

17. A contact formed by the process of Claim 1.

18. A contact for connecting a conductor to at least one region beneath the top surface of a semiconductor substrate, characterized by a conductive material deposited preferentially by CVD on silicon walls in a trench extending from the surface of, and into, the substrate.

0255973

Fig. 1
prior art

FIG. 14c

Fig 14d

0255973

Fig.2

Fig.3

Fig.4a

Fig.4b

Fig.5a

Fig.5b

Fig.6

Fig.7a

↓ to 8c

Fig.7b

0255973

from
7a or 7b

Fig. 8c

Fig. 8d

phosphorus

Fig 9c

phosphorus

Fig. 9d

BORON

Fig. 10c

BORON

Fig. 10d

Arsenic

Fig. 11c

Arsenic

Fig. 11d

etch

Fig. 12c

etch

Fig. 12d

Fig. 13c

Fig. 13d